# FASCICULE DE BREVET EUROPEEN

(11) **EP 4 400 471 B1**
(45) Date de publication et mention de la délivrance du brevet: **12.11.2025**
(21) Numéro de dépôt: 23220619.3
(22) Date de dépôt: 28.12.2023
(51) Int. Cl.: B81B 3/00, B81B 5/00

(54) **SYSTEME ÉLECTROMÉCANIQUE COMPRENANT DES MOYENS CAPACITIFS DE MESURE OU D'ACTIONNEMENT**
ELEKTROMECHANISCHES SYSTEM MIT KAPAZITIVEN MESS- ODER BETÄTIGUNGSMITTELN
ELECTROMECHANICAL SYSTEM COMPRISING CAPACITIVE MEASURING OR ACTUATING MEANS

(30) Priorité: 30.12.2022 FR 2214687
(43) Date de publication de la demande: 17.07.2024
(73) Titulaire: Commissariat à l'Energie Atomique et aux Energies Alternatives, 75015 Paris (FR)
(72) Inventeur: JOET, Loïc, 38054 Grenoble Cedex 09 (FR); DAGHER, Samer, 38054 Grenoble Cedex 09 (FR)
(74) Mandataire: Cabinet Camus Lebkiri

(56) Documents cités:
- EP-A1- 3 975 588

## Description

### DOMAINE TECHNIQUE DE L'INVENTION

Le domaine technique de l'invention est celui des systèmes électromécaniques, notamment de type microsystème électromécanique (MEMS, pour « microelectromechanical systems » en anglais) ou nanosystème électromécanique (NEMS, pour « nanoelectromechanical system »). L'invention concerne plus particulièrement un système électromécanique comprenant un élément mobile, des moyens capacitifs de mesure ou d'actionnement et un dispositif de transmission d'un mouvement entre l'élément mobile et les moyens capacitifs de mesure ou d'actionnement. Un tel système peut être employé en tant que transducteur électroacoustique (ex. microphone, haut-parleur...) ou capteur de pression différentielle.

### ARRIERE-PLAN TECHNOLOGIQUE DE L'INVENTION

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. Un exemple figure dans le document EP3 975 588 A1. La figure 1 représente un exemple de microphone à détection capacitive 1, décrit dans le brevet FR3114584B1.

Le microphone 1 comprend un bâti (non représenté) délimitant au moins en partie une première zone 11 et une deuxième zone 12, un élément mobile 13 par rapport au bâti et un dispositif de transmission 14 d'un mouvement entre la première zone 11 et la deuxième zone 12. Les première et deuxième zones 11-12 du microphone 1 sont isolées l'une de l'autre de manière étanche.

L'élément mobile 13, aussi appelé piston, est en contact avec la première zone 11. Il comprend une membrane 131 et une structure de rigidification 132 de la membrane. La membrane 131 du piston 13 a pour rôle de récolter sur toute sa surface une différence de pression entre ses deux faces, pour en déduire une variation de la pression atmosphérique. Une face de la membrane 131 est soumise à la pression atmosphérique (dont on souhaite détecter la variation) et une face opposée de la membrane 131 est soumise à une pression de référence.

En outre, le microphone 1 comprend des moyens de détection capacitive 15 disposés dans la deuxième zone 12. Ces moyens de détection capacitive 15 permettent de mesurer le déplacement du piston 13, et donc la différence de pression entre ses deux faces. Ils comprennent de préférence une électrode mobile 151 et au moins une électrode fixe disposée en regard de l'électrode mobile 151. Les électrodes forment les armatures d'un condensateur dont la capacité varie en fonction du déplacement du piston 13.

Le dispositif de transmission 14 est monté mobile en rotation par rapport au bâti, au moyen de plusieurs articulations pivot 16. Le dispositif de transmission 14 comprend deux premiers bras de transmission 141 s'étendant dans la première zone 11, deux deuxièmes bras de transmission 142 s'étendant dans la deuxième zone 12 et deux arbres de transmission 143 s'étendant en partie dans la première zone 11 et en partie dans la deuxième zone 12. Chaque arbre de transmission 143 relie un premier bras de transmission 141 à un deuxième bras de transmission 142.

Chaque premier bras de transmission 141 comprend une première extrémité couplée au piston 13 et une deuxième extrémité opposée, couplée à l'arbre de transmission 143 associé. Chaque deuxième bras de transmission 142 comprend une première extrémité couplée à l'électrode mobile 151 des moyens de détection capacitive 15 et une deuxième extrémité opposée, couplée à l'arbre de transmission 143 associé.

Le brevet FR3059659B1 décrit un microphone à détection capacitive semblable à celui de la figure 1. Les moyens de détection capacitive comprennent une électrode mobile et deux électrodes fixes entre lesquelles est disposée l'électrode mobile. Les électrodes forment les armatures de deux condensateurs dont les capacités varient dans des sens opposés en fonction du déplacement du piston. La mesure du déplacement du piston est alors une mesure différentielle.

Pour réaliser une telle mesure différentielle, les condensateurs sont au préalable chargés en appliquant une tension de polarisation continue entre l'électrode mobile et les électrodes fixes par l'intermédiaire d'une forte résistance. Le déplacement du piston se traduit par une variation des capacités, et donc une variation de la tension entre les électrodes fixes (la charge des condensateurs étant sensiblement constante aux fréquences audibles, typiquement supérieures à 100 Hz) qui peut être lue par un amplificateur d'instrumentation.

Un inconvénient de ces microphones à détection capacitive est que de l'énergie est perdue dans la déformation du dispositif de transmission 14 et du cadre de l'électrode mobile 151, ce qui représente une perte de signal utile lors de la détection des variations dynamiques de pression.

En outre, ces microphones à détection capacitive peuvent devenir défaillants à cause d'un phénomène d'effondrement de l'électrode mobile, appelé « pull-in » en anglais et commun à tous les systèmes électromécaniques comprenant des moyens capacitifs de mesure ou d'actionnement. Ce phénomène d'effondrement est causé par la force électrostatique, qui tend à rapprocher l'électrode mobile de l'électrode fixe (ou de l'une des électrode fixes) et qui dépend du carré de la tension de polarisation. La force électrostatique, qui dépend aussi du déplacement de l'électrode mobile, peut être approximée au premier ordre par une force constante plus la force exercée par un ressort de raideur négative pour de petits déplacements.

Pour éviter (jusqu'à un certain point) ce phénomène d'effondrement, une force élastique est opposée à la force électrostatique. Cette force élastique peut être générée par des ressorts reliant le cadre de l'électrode mobile au bâti du microphone. Plus la raideur des ressorts est importante, plus la valeur de tension à laquelle la force électrostatique surpasse la force élastique (tension dite d'effondrement ou « pull-in voltage » en anglais) est importante et plus l'électrode mobile peut être polarisée à une tension élevée (la sensibilité du microphone augmente avec la tension de polarisation).

La composante linéaire (raideur négative) de la force électrostatique, ainsi que le risque d'effondrement associé, sont maximaux en régime statique, lorsque la tension appliquée aux bornes de la capacité est constante. Ils imposent une forte raideur en opposition. En revanche, lors de la détection des variations dynamiques de pression (donc en régime dynamique), la composante linéaire de la force électrostatique exercée sur l'électrode mobile est moindre, voire nulle, et n'aide pas à assouplir le système. Le piston doit alors collecter suffisamment d'énergie pour comprimer les ressorts et déplacer l'électrode mobile. La raideur des ressorts introduits pour lutter contre l'effondrement de l'électrode mobile représente donc une perte de signal utile lors de la détection des variations dynamiques de pression.

Ainsi, l'augmentation de la tension d'effondrement par augmentation de la raideur des ressorts et la diminution des pertes d'énergie dans les systèmes électromécaniques à détection capacitive ou actionnement capacitif sont antinomiques.

### RESUME DE L'INVENTION

On constate qu'il existe un besoin de prévoir un système électromécanique à détection capacitive ou actionnement capacitif présentant un meilleur compromis entre tension d'effondrement et pertes d'énergie.

Selon un premier aspect de l'invention, on tend à satisfaire ce besoin en prévoyant un système électromécanique comprenant :
- un bâti ;
- un élément mobile par rapport au bâti, en contact avec une première zone ;
- des moyens capacitifs de mesure ou d'actionnement comprenant une électrode mobile par rapport au bâti, située dans une deuxième zone isolée de manière étanche de la première zone et au moins une électrode fixe par rapport au bâti, appelée contre-électrode, l'électrode mobile comprenant une membrane et une structure de rigidification de la membrane ;
- un dispositif de transmission d'un mouvement entre l'élément mobile et l'électrode mobile, le dispositif de transmission étant mobile en rotation par rapport au bâti au moyen d'une pluralité d'articulations pivot ; et
- des moyens élastiques reliés à l'électrode mobile et configurés pour générer une force élastique qui s'oppose au mouvement de l'électrode mobile.

Le système électromécanique est remarquable en ce que la structure de rigidification de l'électrode mobile est solidaire du dispositif de transmission et ancrée au dispositif de transmission au niveau d'une partie au moins des articulations pivot.

Le terme « solidaire » signifie qu'il n'y a pas de mouvement relatif entre la structure de rigidification de l'électrode mobile et le dispositif de transmission. Plus particulièrement, il n'y a pas de transformation du mouvement entre le dispositif de transmission et l'électrode mobile (par exemple, passage d'une rotation du dispositif de transmission à une translation de l'électrode mobile) et donc pas de perte d'énergie associée à cette transformation.

La chaîne de transmission des efforts mécaniques entre l'élément mobile et l'électrode mobile (cette chaîne comprenant les différents éléments du dispositif de transmission) est réduite au maximum, grâce l'ancrage de l'électrode mobile au niveau des articulations pivot. Les pertes d'énergie par déformation (élastique) du dispositif de transmission sont par conséquent réduites, ce qui se traduit, dans le cas d'un microphone ou d'un capteur de pression différentielle, par un signal utile plus élevé en sortie des moyens de détection capacitive (plus grand déplacement de l'électrode mobile).

Les pertes d'énergie sont ainsi restreintes à la déformation (utile) des moyens élastiques destinés à lutter contre l'effondrement de l'électrode mobile (moyens dits « anti-pull-in »), en diminuant la déformation (inutile) du dispositif de transmission.

Outre les caractéristiques qui viennent d'être évoquées dans les paragraphes précédents, le système électromécanique selon l'invention peut présenter une ou plusieurs caractéristiques complémentaires parmi les suivantes, considérées individuellement ou selon toutes les combinaisons techniquement possibles :
- le dispositif de transmission comprend des premiers éléments s'étendant dans la première zone et des deuxièmes éléments s'étendant en partie dans la première zone et en partie dans la deuxième zone, et la structure de rigidification de l'électrode mobile est reliée aux premiers éléments du dispositif de transmission par les deuxièmes éléments ;
- les premiers éléments du dispositif de transmission présentent une épaisseur comprise entre 5 µm et 800 µm, de préférence entre 50 µm et 200 µm ;
- les premiers éléments du dispositif de transmission comprennent deux bras de transmission et une poutre transversale reliant les deux bras de transmission, chacun des bras de transmission comprenant une première extrémité couplée à l'élément mobile et une deuxième extrémité solidaire de la poutre transversale ;
- les premiers éléments du dispositif de transmission comprennent :
   - un arbre de transmission présentant un axe longitudinal de rotation ; et
   - une pluralité de bras de transmission, chacun des bras de transmission comprenant une première extrémité couplée à l'élément mobile et une deuxième extrémité solidaire de l'arbre de transmission ;
la structure de rigidification de l'électrode mobile étant solidaire de l'arbre de transmission, d'où il résulte que l'électrode mobile est montée mobile en rotation autour du premier axe longitudinal de rotation ;
- la structure de rigidification de l'électrode mobile comprend une pluralité de poutres s'étendant parallèlement les unes aux autres et une partie au moins des poutres sont ancrées au dispositif de transmission, chaque poutre de ladite au moins une partie étant ancrée au niveau d'une articulation pivot correspondant à ladite poutre ;
- chaque poutre de ladite au moins une partie est ancrée au dispositif de transmission à la moitié de sa longueur ;
- chaque poutre de ladite au moins une partie présente une largeur qui décroit en s'éloignant de l'articulation pivot correspondante ;
- le nombre de poutres est supérieur ou égal au nombre d'articulations pivot de ladite au moins une partie ;
- chaque articulation pivot de ladite au moins une partie peut comprendre un élément d'isolation étanche apte à se déformer élastiquement et assurant l'étanchéité entre la première zone et la deuxième zone, lesdits moyens élastiques comprenant l'élément d'isolation étanche de ladite au moins une partie des articulations pivot ;
- chaque articulation pivot de ladite au moins une partie comprend en outre deux lames de torsion s'étendant chacune entre une portion du bâti et la structure de rigidification de l'électrode mobile, lesdits moyens élastiques comprenant en outre les lames de torsion de ladite au moins une partie des articulations pivot ;
- le système électromécanique comprend en outre des moyens pour stopper un effondrement de l'électrode mobile avant qu'elle ne touche l'électrode fixe et ne crée un court-circuit, lesdits moyens étant situés à une extrémité ou aux extrémités d'une ou plusieurs poutres ;
- les moyens capacitifs de mesure ou d'actionnement comprennent deux contre-électrodes fixes par rapport au bâti, une partie au moins de la membrane de l'électrode mobile étant située entre les deux contre-électrodes ;
- chaque contre-électrode comprend une première portion et une deuxième portion situées de part et d'autre de la membrane et de part et d'autre des articulations pivot de ladite au moins une partie, les première et deuxième portions de chaque contre-électrode étant reliées électriquement ;
- la première portion de chaque contre-électrode comprend une pluralité de blocs séparés par la structure de rigidification de l'électrode mobile et chaque bloc de la première portion est relié électriquement à la deuxième portion de la contre-électrode par un connecteur passant entre deux articulations pivot successives de ladite au moins une partie ; et
- les articulations pivot de ladite au moins une partie sont alignées.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 est une vue en perspective partielle d'un microphone à détection capacitive selon l'art antérieur ;
- la figure 2 est une vue en perspective partielle d'un système électromécanique selon un premier mode de réalisation de l'invention, ce système électromécanique comprenant des moyens capacitifs de détection ou d'actionnement ;
- la figure 3 est une vue de dessus du système électromécanique de la figure 2, montrant une partie des moyens capacitifs de détection ou d'actionnement ;
- la figure 4A est une vue en coupe du système électromécanique selon le plan de coupe A-A de la figure 3 ;
- la figure 4B est une vue en coupe du système électromécanique selon le plan de coupe B-B de la figure 3 ;
- la figure 4C est une vue en coupe du système selon le plan de coupe C-C de la figure 3 ;
- la figure 5 est une vue en perspective partielle d'un système électromécanique selon un deuxième mode de réalisation de l'invention ;
- la figure 6 est une vue de dessus du système électromécanique de la figure 5, montrant une partie des moyens capacitifs de détection ou d'actionnement ; et
- la figure 7 est une vue en perspective de moyens pour empêcher une détérioration des moyens capacitifs de détection ou d'actionnement dans le système électromécanique de la figure 2 ou de la figure 5.

Pour plus de clarté, les éléments identiques ou similaires sont repérés par des signes de référence identiques sur l'ensemble des figures.

### DESCRIPTION DETAILLEE

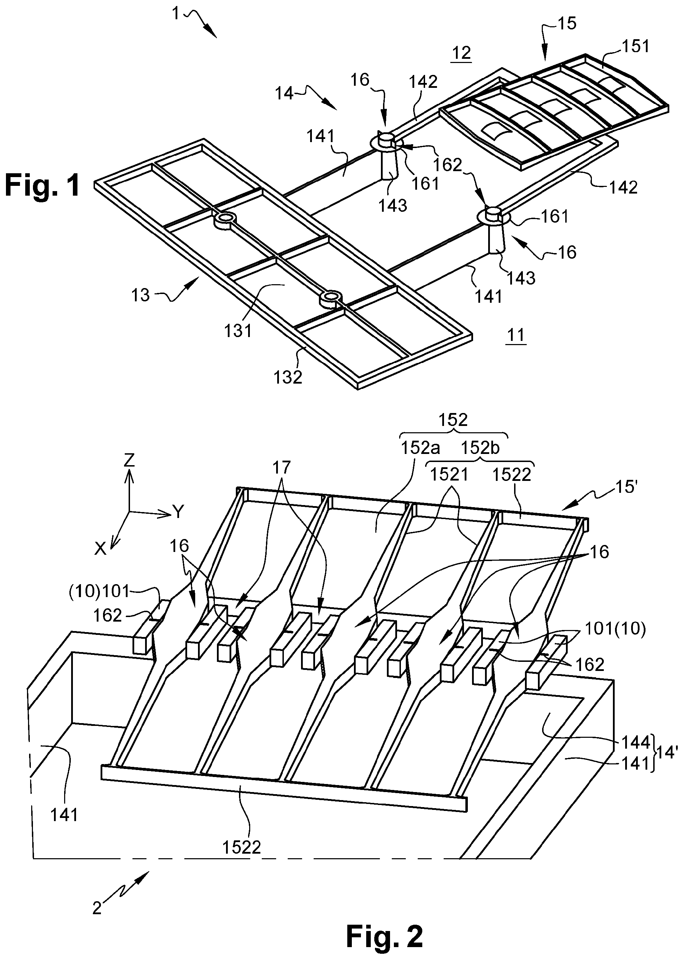

Les figures 2, 3 et 4A à 4C représentent une partie d'un système électromécanique 2 à détection capacitive ou actionnement capacitif selon un premier mode de réalisation de l'invention. Ce système électromécanique 2 peut former un transducteur électroacoustique, par exemple un microphone ou un haut-parleur, ou un capteur de pression différentielle. Dans la description qui suit, on prendra l'exemple d'un microphone à détection capacitive.

Il est fait référence à la figure 1 pour les éléments du système électromécanique 2 non représentées sur les figures 2, 3 et 4A à 4C.

A l'instar du microphone 1 de la figure 1, le système électromécanique 2 comprend :
- un bâti 10 ;
- un élément mobile 13 par rapport au bâti 10, en contact avec une première zone 11 ;
- des moyens de détection (ou mesure) capacitive 15' comprenant une électrode mobile 152 par rapport au bâti, l'électrode mobile 152 étant située dans une deuxième zone 12 isolée de manière étanche de la première zone 11 ; et
- un dispositif de transmission 14' d'un mouvement entre l'élément mobile 13 et l'électrode mobile 152 des moyens de détection capacitive 15', autrement dit entre la première zone 11 et la deuxième zone 12.

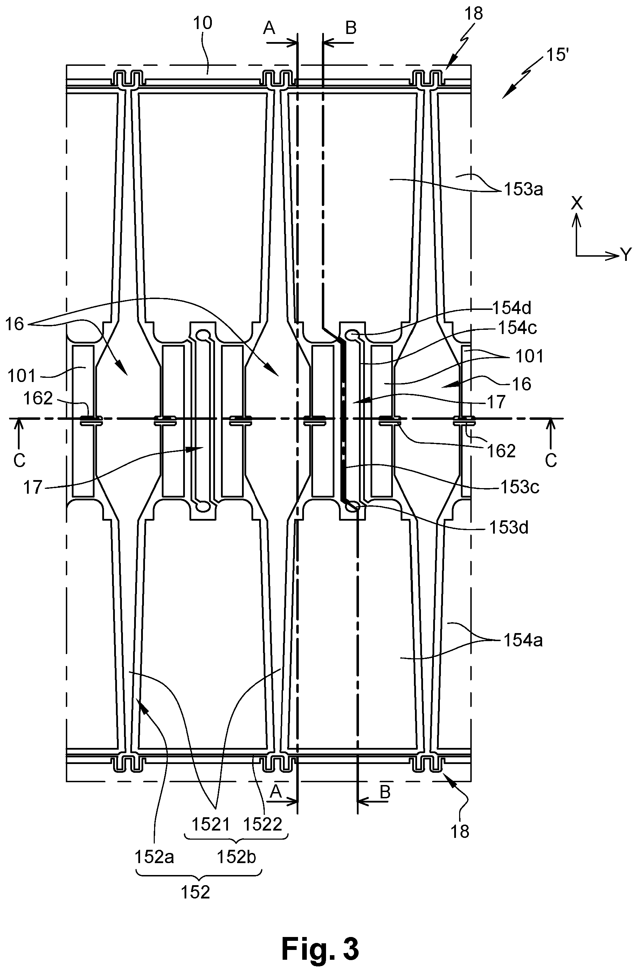

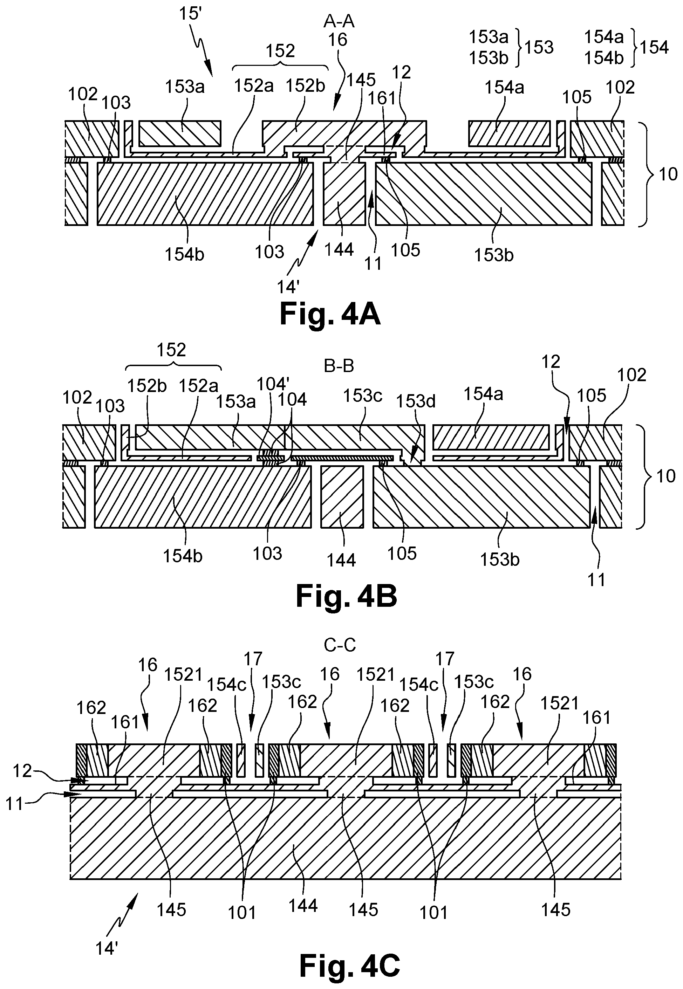

La figure 2 est une vue en perspective montrant des premières portions 101 du bâti 10, une partie seulement du dispositif de transmission 14' et l'électrode mobile 152 des moyens de détection capacitive 15'. La figure 3 est une vue de dessus montrant seulement une partie des moyens de détection capacitive 15' (dont l'électrode mobile 152). Les figures 4A à 4C sont différentes vues de coupe du système électromécanique 2, respectivement selon les plans de coupe A-A, B-B et C-C représentés sur la figure 3. Elles représentent en partie le bâti 10, le dispositif de transmission 14' et les moyens de détection capacitive 15'.

L'élément mobile 13, appelé ci-après piston, peut être mobile (par rapport au bâti) en rotation ou en translation. Il peut être identique à celui décrit en référence à la figure 1. En particulier, il peut comprendre une membrane 131 et une structure de rigidification 132 de la membrane 131, aussi appelée squelette ou armature.

La membrane 131 du piston 13 peut délimiter en partie un volume fermé dit de référence, où règne une pression de référence. Elle sépare ce volume de référence d'une cavité ouverte sur l'environnement extérieur, ici l'air. Une face de la membrane 131 est donc soumise à la pression de référence et une face opposée de la membrane 131 est soumise à la pression atmosphérique (dont on souhaite détecter la variation dans le cas d'un microphone). Alternativement, le volume de référence peut être quasi-fermé, au sens où il existe une tranchée autour du piston (qui est détouré). Cette tranchée permet au piston de bouger et autorise une fuite d'air entre le volume de référence et l'extérieur. Cette fuite est faible pour que les pressions puissent s'égaliser lentement, de sorte à filtrer uniquement les variations de pression de basses fréquences (< 100 Hz).

La première zone 11 englobe la cavité ouverte sur l'environnement extérieur, soumise à la pression atmosphérique, et le volume de référence soumis à la pression de référence.

Les moyens de détection capacitive 15' permettent de mesurer le déplacement du piston 13, et donc la différence de pression entre ses deux faces. Outre l'électrode mobile 152, ils comprennent au moins une électrode fixe par rapport au bâti 10, appelée « contre-électrode » et disposée en regard de l'électrode mobile 152. Les électrodes mobile et fixe(s) forment les armatures d'un ou plusieurs condensateurs dont la capacité varie en fonction du déplacement du piston 13.

La deuxième zone 12 est avantageusement une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 10 mbar, et de préférence inférieure à 1 mbar. Ainsi, la deuxième zone 12 est ici soumise à une pression bien inférieure à la pression atmosphérique ou la pression de référence.

En référence à la figure 2, l'électrode mobile 152 comprend une membrane 152a et une structure de rigidification 152b de la membrane 152a. La structure de rigidification 152b de l'électrode mobile 152 comprend de préférence une pluralité de premières poutres 1521 s'étendant parallèlement les unes aux autres. Elle peut en outre comprendre des deuxièmes poutres 1522 reliant les premières poutres 1521 à leurs extrémités. Les premières poutres 1521 s'étendent dans une première direction X, de préférence d'un premier bord à un deuxième bord opposé de l'électrode mobile 152. Elles sont avantageusement espacées régulièrement les unes des autres, pour rigidifier la membrane 152a de manière uniforme. Les deuxièmes poutres 1522 s'étendent de préférence dans une deuxième direction Y perpendiculaire à la première direction X (donc perpendiculairement aux premières poutres 1521). Un repère orthogonal est ainsi défini, avec une troisième direction Z perpendiculaire aux première et deuxième directions X-Y.

L'électrode mobile 152 présente avantageusement un ou plusieurs plans de symétrie, par exemple un plan parallèle au plan YZ (donc perpendiculaire aux premières poutres 1521) et un autre plan parallèle au plan XZ.

Le dispositif de transmission 14' est monté mobile en rotation par rapport au bâti 10, au moyen de plusieurs articulations pivot 16. Il comprend des premiers éléments s'étendant dans la première zone 11, par exemple deux bras de transmission 141 et une poutre transversale 144 reliant les deux bras de transmission 141. De préférence, les bras de transmission 141 s'étendent dans la première direction X et la poutre transversale 144 s'étend dans la deuxième direction Y. Chacun des bras de transmission 141 comprend une première extrémité couplée au piston 13 (cf. Fig.1) et une deuxième extrémité solidaire de la poutre transversale 144 (cf. Fig.2).

Les articulations pivot 16, par exemple au nombre de 5 sur la figure 2, sont de préférence alignées, ici dans la deuxième direction Y. Plus particulièrement, elles sont situées à la verticale de la poutre transversale 144. Elles sont avantageusement espacées régulièrement les unes des autres.

Une particularité du système électromécanique 2 est que la structure de rigidification 152b de l'électrode mobile 152 est solidaire du dispositif de transmission 14'. L'électrode mobile 152 se déplace donc par rapport au bâti 10 selon le même mouvement de rotation que le dispositif de transmission 14'. Elle tourne ici autour d'un axe de rotation parallèle à la deuxième direction Y. Le système électromécanique 2 est donc dépourvu d'organes de transformation du mouvement entre le dispositif de transmission 14' et l'électrode mobile 152, tels que des lames de torsion pour passer d'une rotation à une translation. Il en résulte qu'aucune énergie n'est perdue dans ces organes de transformation (par exemple, par déformation des lames de torsion).

Une autre particularité du système électromécanique 2 est que la structure de rigidification 152b de l'électrode mobile 152 est ancrée, ou fusionnée, au dispositif de transmission 14' au niveau des articulations pivot 16. Par rapport au microphone 1 de la figure 1, le système électrostatique 2 est donc dépourvu des deuxièmes bras de transmission 142 s'entendant dans la deuxième zone 12.

Plus particulièrement, la structure de rigidification 152b de l'électrode mobile 152 est reliée aux premiers éléments du dispositif de transmission 14', et plus particulièrement à la poutre transversale 144, par des deuxièmes éléments 145 visibles sur les figures 4A et 4C. Ces deuxièmes éléments 145 du dispositif de transmission 14', appelés piliers, sont semblables aux arbres de transmission 143 de la figure 1 car ils s'étendent en partie dans la première zone 11 et en partie dans la deuxième zone 12. En effet, l'étanchéité entre la première zone 11 et la deuxième zone 12 s'effectue également au niveau des articulations pivot 16.

Le dispositif de transmission 14' est ainsi réduit aux premiers éléments s'étendant exclusivement dans la première zone 11 (ici les bras de transmission 141 et la poutre transversale 144) et aux deuxièmes éléments 145 qui s'étendent en partie dans la première zone 11 et en partie dans la deuxième zone 12. Cette réduction du dispositif de transmission 14' permet de limiter les pertes d'énergie. Il n'y a notamment plus de pertes par déformation des deuxièmes bras de transmission 142.

En outre, les premiers éléments du dispositif de transmission 14' sont relativement rigides (bien plus que les deuxièmes bras de transmission 142 du microphone 1), car ils présentent une épaisseur importante, de préférence comprise entre 5 µm et 800 µm, et plus préférentiellement entre 50 µm et 200 µm. Ils sont avantageusement formés par gravure anisotrope d'un substrat en silicium. Ce substrat peut être aminci, jusqu'à une épaisseur comprise entre 50 µm et 200 µm. Alternativement, les premiers éléments du dispositif de transmission 14' sont formés par une couche épitaxiée d'épaisseur comprise entre 5 µm et 40 µm.

Le système électromécanique 2 est particulièrement compact, car plusieurs fonctions, à savoir la mise en rotation du dispositif de transmission 14', l'étanchéité entre les deux zones 11-12 et la connexion à l'électrode mobile 152, sont réalisées au même endroit.

L'ancrage entre la structure de rigidification 152b et le dispositif de transmission 14' est de préférence réalisé au moyen des premières poutres 1521. Une partie au moins d'entre elles sont fusionnées au dispositif de transmission 14', chacune au niveau d'une articulation pivot 16 correspondante. Le point d'ancrage de chaque première poutre 1521 se situe avantageusement à la moitié de sa longueur. Ainsi, l'axe de rotation se situe dans un des plans de symétrie de l'électrode mobile 152 (celui perpendiculaire aux première poutres 1521). La longueur des premières poutres 1521 est mesurée dans la première direction X, tandis que leur largeur est mesurée dans la deuxième direction Y.

Chaque première poutre 1521 fusionnée avec le dispositif de transmission 14' présente avantageusement une largeur qui décroit en s'éloignant de l'articulation pivot 16 correspondante. Autrement dit, la largeur des premières poutres 1521 est maximale au niveau des articulations pivot 16. Ainsi, la structure de rigidification 152b est la plus rigide aux endroits où elle est la plus sollicitée mécaniquement, c'est-à-dire près de l'axe de rotation. Cela contribue à réduire les pertes d'énergie par déformation, sans impacter négativement l'inertie de l'électrode mobile 152 et donc la fréquence de résonnance du système électromécanique 2.

Dans ce premier mode de réalisation du système électromécanique 2, chacune des premières poutres 1521 de la structure de rigidification 152b est fusionnée au dispositif de transmission 14'. En d'autres termes, à chaque première poutre 1521 est associée une articulation pivot 16. Le nombre d'articulations pivot 16 est donc au moins égal au nombre de première poutres 1521. Cette disposition permet d'aménager un espace 17 entre deux articulations pivot 16 successives.

Le bâti 10 peut comprendre, pour chaque articulation pivot 16, deux premières portions 101 distinctes disposées de part et d'autre de la première poutre 1521 associée à l'articulation pivot. La première poutre 1521 est de préférence reliée à chacune des premières portions 101 du bâti 10 par une lame de torsion 162.

Comme cela est représenté par les figures 3, 4A à 4C, les moyens de détection capacitive 15' comprennent de préférence deux contre-électrodes 153-154 : une première contre-électrode 153 dite positive et une deuxième contre-électrode 154 dite négative. Préférentiellement, une partie au moins de la membrane 152 de l'électrode mobile est située entre les deux contre-électrodes 153-154 (cf. Figs.4A-4C). L'électrode mobile 152 et les contre-électrodes 153-154 forment ainsi les armatures de deux condensateurs dont les capacités varient dans des sens opposés. Une mesure différentielle du déplacement du piston 13 peut être ainsi obtenue. Les surfaces des contre-électrodes 153-154 en regard de l'électrode mobile 152 sont avantageusement identiques, grâce à une symétrie des moyens de détection capacitive 15' par rapport aux articulations pivot 16 (le plan de symétrie est confondu avec le plan de coupe C-C).

Avantageusement, chacune des contre-électrodes 153, 154 comprend une première portion 153a, 154a et une deuxième portion 153b, 154b situées de part et d'autre de la membrane 152a de l'électrode mobile 152 et de part et d'autre des articulations pivot 16. La première portion 153a, 154a, dite supérieure, et la deuxième portion 153b, 154b, dite inférieure, d'une même contre-électrode sont reliées électriquement. Cette disposition permet d'obtenir une mesure totalement différentielle, même si la distance entre la membrane 152a et les portions supérieures 153a-154a des contre-électrodes (appelée entrefer supérieur) est différente de la distance entre la membrane 152a et les portions inférieures 153a-154a des contre-électrodes (entrefer inférieur).

Les portions inférieures 153b-154b des contre-électrodes 153-154 peuvent s'étendre sous les première poutres 1521 de la structure de rigidification 152b, de chaque côté des articulations pivot 16. En revanche, les portions supérieures 153a-154a des contre-électrodes 153-154 sont de préférence divisées chacune en plusieurs blocs (ou sous-portions) séparées par les première poutres 1521, comme cela est illustré par la figure 3. Les portions supérieures 153a-154a des contre-électrodes 153-154 étant inscrites dans la structure de rigidification 152b de l'électrode mobile 152, leur surface en regard de la membrane 152a est inférieure à celle des portions inférieures 153b-154b.

Chaque bloc de la portion supérieure 153a de la première contre-électrode 153 peut être relié électriquement à la portion inférieure 153b de cette même contre-électrode par un premier connecteur 153c et un premier via conducteur 153d. De même, chaque bloc de la portion supérieure 154a de la deuxième contre-électrode 154 peut être relié électriquement à la portion inférieure 154b de cette même contre-électrode par un deuxième connecteur 154c et un deuxième via conducteur 154d.

Les premier et deuxième connecteurs 153c-154c s'étendent avantageusement dans l'espace 17 situé entre deux articulations pivot 16. Ainsi, la connexion électrique des portions supérieure et inférieur d'une même contre-électrode est simplifiée et n'augmente pas l'encombrement des moyens de détection capacitive 15'.

Alternativement, les différents blocs d'une portion supérieure de contre-électrode peuvent être reliés directement entre eux, par exemple à la périphérie de l'électrode mobile 152.

En référence aux figures 4A et 4B, les portions inférieures 153b-154b des contre-électrodes 153-154 sont de préférence solidarisées à une portion annulaire 102 du bâti 10, située à la périphérie de l'électrode mobile 152, au moyen de joints annulaires 103, 105 en un matériau électriquement isolant (un joint annulaire par portion inférieure 153b, 154b). Ces joints annulaires 103, 105, par exemple en oxyde de silicium, assurent en outre l'étanchéité entre la première zone 11 et la deuxième zone 12.

En outre, chacun des blocs des portions supérieures 153a, 154a des contre-électrodes 153-154 peut être solidarisé à la portion inférieure 154b, 153b sous-jacente, grâce à (au moins) deux piliers 104 électriquement isolant, de préférence formés du même matériau que celui des joints annulaires 103, 105. Les piliers 104 peuvent être séparés deux à deux par une couche résiduelle 104' formée du même matériau que celui de la membrane 152a de l'électrode mobile 152, par exemple du silicium. L'épaisseur des piliers 104 est alors égal à l'entrefer supérieur et à l'entrefer inférieur. Dans le cas contraire, il n'y a qu'un seul pilier « double », dont l'épaisseur est égale à la somme de l'entrefer supérieur, l'entrefer inférieur et l'épaisseur de la membrane 152a. Le(s) pilier(s) 104 et la couche résiduelle 104' permettent de réduire les capacités parasites entre les portions supérieures 153a, 154a et les portions inférieures 153b-154b des contre-électrodes.

De façon alternative, les moyens de détection capacitive 15' peuvent comprendre qu'une seule contre-électrode (inférieure ou supérieure), deux contre-électrodes supérieure et inférieure mais situées d'un seul côté des articulations pivot 16 (détection pseudo-différentielle) ou encore deux contre-électrodes inférieures ou supérieures disposées de part et d'autre des articulations pivot 16 (détection différentielle).

Comme indiqué précédemment, l'étanchéité entre les première et deuxième zones 11-12 du système électromécanique 2 peut être réalisée au niveau des articulations pivot 16. Comme illustré sur les figures 4A et 4C, chaque articulation pivot 16 comprend un élément d'isolation étanche 161, apte à se déformer élastiquement sous l'effet du déplacement en rotation du dispositif de transmission 14'. L'élément d'isolation étanche 161 se présente de préférence sous la forme d'une membrane d'étanchéité.

Chaque élément d'isolation étanche 161 est de préférence traversé par un deuxième élément 145 associé du dispositif de transmission 14'. L'élément d'isolation étanche 161 s'étend par exemple depuis le deuxième élément 145 associé jusqu'aux portions inférieures 153b-154b des contre-électrodes 153-154 (cf. Fig.4A) et aux premières portions 101 du bâti 10 (cf. Fig.4C), auxquelles il est ancré grâce aux joints annulaires 103, 105 en matériau électriquement isolant.

En outre, chaque articulation pivot 16 comprend avantageusement les deux lames de torsion 162 décrites précédemment, en référence à la figure 2. Les lames de torsion 162 sont dimensionnées de sorte à pouvoir se déformer en torsion et permettre la rotation du dispositif de transmission 14' et de l'électrode mobile 152, tout en limitant leurs mouvements de translation, notamment selon la troisième direction Z (translation dite « hors plan »). Les deux lames de torsion 162 relient la structure de rigidification 152b de l'électrode mobile 152 (fusionnée au deuxième élément 145 du dispositif de transmission 14') aux premières portions 101 du bâti 10 (cf. également Fig.4C). Elles sont de préférence alignées et disposées de façon diamétralement opposée par rapport à la première poutre 1521 associée à l'articulation pivot 16.

Le système électromécanique 2 comprend des moyens élastiques reliés à l'électrode mobile 152 et configurés pour générer une force élastique qui s'oppose au mouvement de l'électrode mobile 152. Le rôle de ces moyens élastiques est de lutter contre le phénomène d'effondrement (appelé « pull-in » en anglais) de l'électrode mobile 152. Leur raideur influe sur la tension d'effondrement (ou « pull-in voltage » du système), donc sur la faculté à polariser l'électrode mobile 152, mais également sur les pertes d'énergie.

Les moyens élastiques « anti-pull-in » relient (mécaniquement) la structure de rigidification 152b de l'électrode mobile 152 au bâti 10 et/ou à des éléments solidaires du bâti, tels que les contre-électrodes 153-154, éventuellement par l'intermédiaire des deuxièmes éléments 145 du dispositif de transmission 14'. Ainsi, ne sont pas considérés comme des moyens élastiques « anti-pull-in » la raideur du dispositif de transmission 14' ou la raideur de la structure de rigidification 152b elle-même.

Les moyens élastiques « anti-pull-in » comprennent ici les éléments d'isolation étanches 161 et, le cas échéant, les lames de torsion 162. Les éléments d'isolation étanches 161 et les lames de torsion 162 remplissent ainsi plusieurs fonctions simultanément.

Les moyens élastiques « anti-pull-in » sont reliées à la structure de rigidification 152b là où elle est la plus rigide, à savoir au niveau des articulations pivot 16. Ainsi, la raideur des moyens élastiques « anti-pull-in » n'est pas dégradée par des éléments en série de raideur trop faible. Cette raideur peut en outre être contrôlée facilement, en jouant sur les dimensions des éléments d'isolation étanches 161 et des lames de torsion 162. Les éléments d'isolation étanches 161 peuvent être délimités par gravure anisotrope d'une couche sacrificielle (par exemple en SiO₂) et sont réalisés dans une couche structurelle dont l'épaisseur est maitrisée. Ce type de gravure permet un bon contrôle des dimensions des éléments d'isolation étanches 161. La raideur des éléments d'isolation étanches 161 présente en conséquence une faible dispersion (principalement entre les différents systèmes électromécaniques fabriqués sur une même plaquette ou sur différentes plaquettes).

Les éléments d'isolation étanches 161 et le cas échéant, les lames de torsion 162, constituent avantageusement les seuls moyens « anti-pull-in » du système électromécanique 2. Ainsi, le système électromécanique 2 est particulièrement compact.

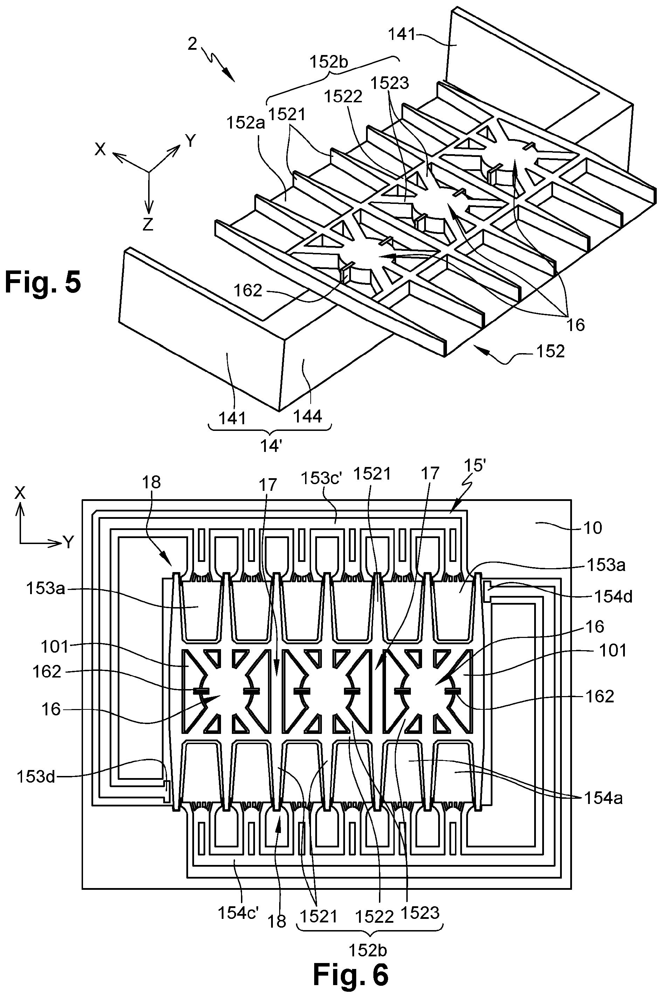

Les figures 5 et 6 représentent un deuxième mode de réalisation du système électromécanique 2. La figure 5 est une vue en perspective d'une partie du système électromécanique 2, similaire à celle de la figure 2. La figure 5 est une vue de dessus, similaire à celle de la figure 3, montrant les moyens de détection capacitive 15' (à l'exception des portions inférieures des contre-électrodes).

Ce deuxième mode de réalisation diffère du premier mode de réalisation essentiellement dans la conception des moyens de détection capacitive 15'. Le dispositif de transmission 14' est notamment identique à celui de la figure 2 (bras de transmission 141 et poutre transversale 144) et les articulations pivot 16 sont construites de la façon décrite en relation avec les figures 4A-4C (éléments d'isolation étanche et lames de torsion 162).

La structure de rigidification 152b de l'électrode mobile 152 comprend toujours des premières poutres 1521, mais en nombre supérieur au nombre d'articulations pivot 16 servant à l'ancrage de l'électrode mobile 152. Ainsi, des premières poutres 1521 ne sont pas fusionnées avec le dispositif de transmission 14'. Elles s'étendent sur les bords longitudinaux (dans le sens de la longueur, soit selon la première direction X) de l'électrode mobile 152 ou entre deux articulations pivot 16 successives.

Les deuxième poutres 1522 ne connectent plus les première poutres 1521 à leurs extrémités, mais plus près des articulations pivot 16, par exemple à mi-distance entre l'axe de rotation (passant par les lames de torsion 162) et le bord transversal de l'électrode mobile 152.

En plus d'augmenter la largeur des premières poutres 1521 au niveau des articulations pivot 16 (cf. Fig.6), ou alternativement, des poutres obliques 1533 sont ajoutées aux premières poutres 1521 fusionnées avec le dispositif de transmission 14' pour dessiner des croisillons, ce qui augmente encore la rigidité de la structure de rigidification 152b au niveau des articulations pivot 16 (là où elle est le plus sollicitée).

L'espace 17 entre deux articulations 16 successives est occupé par une ou plusieurs premières poutres 1521 (non fusionnées avec le dispositif de transmission 14'), ce qui oblige à modifier la façon dont sont connectées les portions supérieure et inférieure des contre-électrodes 153-154.

En référence à la figure 6, les différents blocs de la portion supérieure 153a de la première contre-électrode 153 sont reliés électriquement entre eux par une première piste conductrice 153c' qui s'étend à la périphérie de l'électrode mobile 152. Cette première piste conductrice 153c', dite extérieure, contourne l'électrode mobile 152 jusqu'au premier via conducteur 153d pour se connecter à la portion inférieure de la première contre-électrode 153, située de l'autre côté des articulations pivot 16. De la même façon, les différents blocs de la portion supérieure 154a de la deuxième contre-électrode 154 sont reliés électriquement entre eux par une deuxième piste conductrice 154c' qui s'étend à la périphérie de l'électrode mobile 152 jusqu'au deuxième via conducteur 154b.

D'une manière commune aux deux modes de réalisation (cf. Figs. 3 et 6), le système électromécanique 2 peut comprendre des moyens 18 pour stopper l'effondrement de la membrane 152a de l'électrode mobile 152, avant qu'elle ne se colle à l'une des contre-électrodes, lorsque la tension de polarisation de l'électrode mobile 152 est telle que la force électrostatique devient supérieure à la force élastique (autrement dit, en cas de « pull-in »). Ces moyens 18 sont situés à une extrémité ou aux extrémités d'une ou plusieurs premières poutres 1521, de préférence de toutes les premières poutres 1521, et comprennent par exemple des butées. Ils visent essentiellement à empêcher une dégradation de l'électrode mobile 152 due à un cas de court-circuit avec une contre électrode.

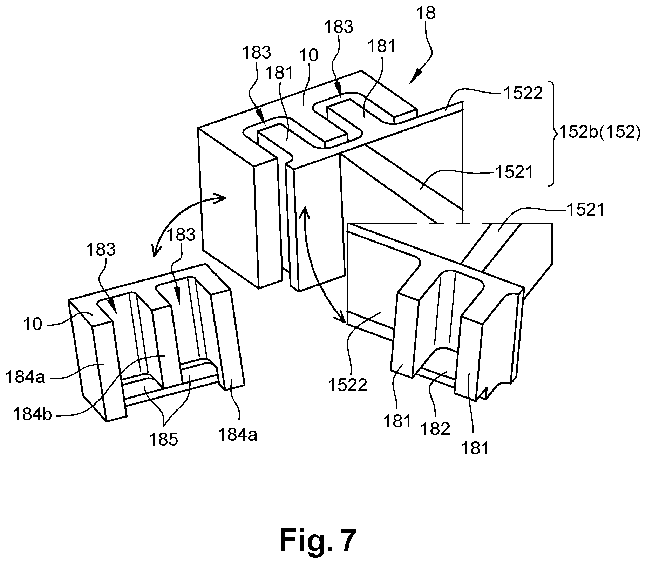

La figure 7 représente un exemple de réalisation des moyens 18 pour empêcher l'effondrement de l'électrode mobile 152. La structure de rigidification 152b de l'électrode mobile 152 comprend à l'extrémité de la première poutre 1521 deux doigts 181 et une membrane 182 reliant les deux doigts 181 à l'une de leurs extrémités. Le bâti 10 comprend deux cavités 183, délimitées latéralement par deux doigts extérieurs 184a et un doigt intérieur 184b (disposé entre les doigts extérieurs 184a), et deux membranes 185 formant le fond des cavités 183. Les doigts 181 de la structure de rigidification 152b sont disposés à l'intérieur des cavités 183 du bâti 10.

Selon le sens du déplacement (rotation) de l'électrode mobile 152, soit les doigts 181 de la structure de rigidification 152b viennent en butée contre les membranes 185 du bâti 10, soit la membrane 182 de la structure de rigidification 152b vient en butée contre le doigt intérieur 184b du bâti 10.

Le système électromécanique 2 décrit ci-dessus peut être fabriqué grâce aux procédés décrits dans les brevets FR3059659B1 et FR3114584B1, notamment en partant d'un empilement de couches comprenant successivement un substrat, une première couche sacrificielle et une première couche structurelle. L'empilement peut notamment être une structure multicouche de type silicium sur isolant ou SOI (« Silicon On Insulator » en anglais), communément appelée substrat SOI.

Le substrat sert notamment à réaliser, par gravure, les premiers éléments du dispositif de transmission 14' (bras de transmission 141 et poutre transversale 144), les portions inférieures 153b-154b des contre-électrodes 153-154 et une partie du bâti 10. Le substrat peut être en un matériau semiconducteur, par exemple le silicium.

La première couche structurelle sert notamment à réaliser la membrane 131 du piston 13, la membrane 152a de l'électrode mobile 152, les éléments d'isolation étanches 161 (membranes d'étanchéité) et les membranes 182 et 185 des moyens 18 pour empêcher l'effondrement de l'électrode mobile 152. Elle présente une épaisseur inférieure à celle du substrat, de préférence comprise entre 100 nm et 10 µm, par exemple égale à 1 µm. Elle est de préférence constituée du même matériau que le substrat, par exemple le silicium.

La première couche sacrificielle a vocation à disparaître en partie lors de la fabrication du système électromécanique 2 pour libérer la membrane 131 du piston 13, la membrane 152a de l'électrode mobile 152 et les éléments d'isolation étanches 161. Son épaisseur définit notamment la distance entre la membrane 152a de l'électrode mobile 152 et les portions inférieures 153b-154b des contre-électrodes 153-154 (entrefer inférieur). Cette couche sert également de couche d'arrêt lors de la gravure du substrat, de la membrane 152a, et de la deuxième couche structurelle (couche dite « MEMS » décrite ultérieurement. Les parties restantes de la première couche sacrificielle forment les joints annulaires 103, 105 et les piliers 104 inférieurs. La première couche sacrificielle peut être constituée d'un matériau diélectrique, de préférence un nitrure de silicium ou un oxyde de silicium, par exemple le dioxyde de silicium (SiO₂). Son épaisseur est par exemple comprise entre 100 nm et 10 µm.

Comme décrit dans les brevets précités, une deuxième couche sacrificielle est déposée sur la première couche structurelle et une deuxième couche structurelle est formée sur la deuxième couche sacrificielle, de préférence par épitaxie.

La deuxième couche structurelle est gravée pour délimiter la structure de rigidification 132 du piston 13, la structure de rigidification 152b de l'électrode mobile 152, les lames de torsion 162, les portions supérieures 153a-153b des contre-électrodes 153-154, les premières portions 101 et la deuxième portion annulaire 102 du bâti 10. Elle est avantageusement formée du même matériau que la première couche structurelle, par exemple de silicium. L'épaisseur de la deuxième couche structurelle est de préférence comprise entre 5 µm et 50 µm, par exemple égale à 20 µm.

La structure de rigidification 152b de l'électrode mobile 152 est fusionnée au dispositif de transmission 14', en faisant croître la deuxième couche structurelle directement depuis le substrat, à l'emplacement des articulations pivot 16 (les première et deuxième couche sacrificielles ayant été ouvertes au préalable). Les deuxièmes éléments 145 du dispositif de transmission 14' sont formés au cours de cette croissance par épitaxie.

La deuxième couche sacrificielle sert notamment de couche d'arrêt lors de la gravure de la deuxième couche structurelle. Elle est éliminée en partie pour libérer la membrane 131 du piston 13, la membrane 152a de l'électrode mobile 152 et les éléments d'isolation étanches 161. Son épaisseur définit la distance entre la membrane 152a de l'électrode mobile 152 et les portions supérieures 153a-154a des contre-électrodes 153-154 (entrefer supérieur). La deuxième couche sacrificielle est avantageusement formée du même matériau diélectrique que la première couche sacrificielle, par exemple un oxyde de silicium. Son épaisseur peut être comprise entre 100 nm et 10 µm.

Le système électromécanique selon l'invention n'est pas limité aux modes de réalisation décrits en relation avec les figures 2 à 7 et de nombreuses variantes et modifications du système électromécanique apparaitront à l'homme du métier.

Le dispositif de transmission 14' peut notamment adopter d'autres configurations que celle décrite en relation avec la figure 2. Par exemple, le dispositif de transmission 14' peut comprendre un arbre de transmission présentant un axe longitudinal de rotation et une pluralité de bras de transmission, chacun des bras de transmission comprenant une première extrémité couplée au piston et une deuxième extrémité solidaire de l'arbre de transmission. La structure de rigidification de l'électrode mobile est solidaire de l'arbre de transmission (de la même manière qu'avec la poutre transversale 144) L'électrode mobile est alors montée mobile en rotation autour du premier axe longitudinal de rotation. Les bras de de transmission s'étendent de préférence perpendiculairement à l'arbre de transmission. Le piston peut être mobile (par rapport au bâti) en rotation ou en translation.

Le système électromécanique 2 peut comprendre une ou plusieurs articulations pivot supplémentaires, non représentées par les figures, qui ne sont pas fusionnées avec la structure de rigidification 152b de l'électrode mobile 152 (par exemple des articulations pivot situées à l'extrémité des bras de transmission 141, comme cela est représenté sur la figure 1).

Le système électromécanique 2 a été décrit en prenant pour exemple un microphone à détection capacitive comprenant un piston 13 doté d'une membrane 131 soumise d'une part à la pression atmosphérique et d'autre part à une pression de référence. Le système électromécanique peut cependant former d'autres types de transducteur à détection capacitive, notamment un haut-parleur (émetteur sonore) ou un émetteur ultrasonore (qui sont des transducteurs électroacoustiques), ou encore un capteur de pression différentielle.

Dans le cas d'un capteur de pression différentielle, la première face de la membrane 131 est soumise à une première pression (pas nécessairement la pression atmosphérique) et la deuxième face de la membrane 131 est soumise à une deuxième pression, différente de la première pression. Le déplacement de la membrane 131, sous l'effet de la différence de pression, est mesuré par les moyens de détection capacitive 15'. La membrane 131 du piston est solidaire du bâti 10 de manière à être étanche et la structure de rigidification 132 du piston est absente ou réduite pour ne pas l'ancrer au bâti.

Dans le cas d'un haut-parleur ou d'un émetteur ultrasonore, des moyens d'actionnement capacitif remplacent les moyens de détection capacitive 15'. Ces moyens d'actionnement capacitif comprennent également une électrode mobile et au moins une contre-électrode. L'électrode mobile est mise en mouvement par une force électrostatique et ce mouvement est transmis par le dispositif de transmission 14' jusqu'au piston 13. Le mouvement de la membrane 131 du piston 13 permet d'émettre un son (ou des ultrasons).

Les première et deuxième zones 11-12 isolées de manière étanche ne sont pas nécessairement soumises à des pressions différentes. La première zone 11 peut aussi être un environnement agressif et l'électrode mobile des moyens capacitifs (de détection ou d'actionnement) est placée dans la deuxième zone 12 pour la protéger de cette environnement agressif (en plus de réduire les frottements visqueux, et donc les bruits acoustiques).

Le système électromécanique 2 peut même être dépourvu de moyens d'étanchéité entre les première et deuxième zones 11-12 (ce qui revient à ne considérer qu'une seule zone). Plus particulièrement, les articulations pivot 16 peuvent être dépourvues d'élément d'isolation étanche 161. En effet, les lames de torsion 162 peuvent suffire pour la rotation du dispositif de transmission 14' et comme moyens élastiques « anti-pull-in ».

## Revendications

1. Système électromécanique (2) comprenant :
- un bâti (10) ;
- un élément mobile (13) par rapport au bâti (10), en contact avec une première zone (11) ;
- des moyens capacitifs de mesure ou d'actionnement (15') comprenant une électrode mobile (152) par rapport au bâti, située dans une deuxième zone (12) isolée de manière étanche de la première zone (11), et au moins une électrode fixe (153, 154) par rapport au bâti (10), appelée contre-électrode, l'électrode mobile (152) comprenant une membrane (152a) et une structure de rigidification (152b) de la membrane ;
- un dispositif de transmission (14') d'un mouvement entre l'élément mobile (13) et l'électrode mobile (152), le dispositif de transmission étant mobile en rotation par rapport au bâti (10) au moyen d'une pluralité d'articulations pivot (16) ; et
- des moyens élastiques reliés à l'électrode mobile (152) et configurés pour générer une force élastique qui s'oppose au mouvement de l'électrode mobile (152) ;
**caractérisé en ce que** la structure de rigidification (152b) de l'électrode mobile (152) est solidaire du dispositif de transmission (14') et ancrée au dispositif de transmission au niveau d'une partie au moins des articulations pivot (16).

2. Système (2) selon la revendication 1, dans lequel le dispositif de transmission (14') comprend des premiers éléments s'étendant dans la première zone (11) et des deuxièmes éléments (145) s'étendant en partie dans la première zone (11) et en partie dans la deuxième zone (12), et dans lequel la structure de rigidification (152b) de l'électrode mobile (152) est reliée aux premiers éléments du dispositif de transmission par les deuxièmes éléments (145).

3. Système (2) selon la revendication 2, dans lequel les premiers éléments du dispositif de transmission (14') présentent une épaisseur comprise entre 5 µm et 800 µm, de préférence entre 50 µm et 200 µm.

4. Système (2) selon l'une des revendications 2 et 3, dans lequel les premiers éléments du dispositif de transmission (14') comprennent deux bras de transmission (141) et une poutre transversale (144) reliant les deux bras de transmission (141), chacun des bras de transmission comprenant une première extrémité couplée à l'élément mobile (13) et une deuxième extrémité solidaire de la poutre transversale (144).

5. Système (2) selon l'une quelconque des revendications 1 à 4, dans lequel la structure de rigidification (152b) de l'électrode mobile (152) comprend une pluralité de poutres (1521) s'étendant parallèlement les unes aux autres et dans lequel une partie au moins des poutres (1521) sont ancrées au dispositif de transmission (14'), chaque poutre de ladite au moins une partie étant ancrée au niveau d'une articulation pivot (16) correspondant à ladite poutre.

6. Système (2) selon la revendication 5, dans lequel chaque poutre (1521) de ladite au moins une partie est ancrée au dispositif de transmission (14') à la moitié de sa longueur.

7. Système (2) selon l'une des revendications 5 et 6, dans lequel chaque poutre (1521) de ladite au moins une partie présente une largeur qui décroit en s'éloignant de l'articulation pivot (16) correspondante.

8. Système (2) selon l'une quelconque des revendications 5 à 7, dans lequel le nombre de poutres (1521) est supérieur ou égal au nombre d'articulations pivot (16) de ladite au moins une partie.

9. Système (2) selon l'une quelconque des revendications 5 à 8, comprenant en outre des moyens (18) pour stopper un effondrement de l'électrode mobile (152) avant qu'elle ne touche l'électrode fixe (153, 154) et ne crée un court-circuit, lesdits moyens (18) étant situés à une extrémité ou aux extrémités d'une ou plusieurs poutres (1521).

10. Système (2) selon l'une quelconque des revendications 1 à 9, dans lequel chaque articulation pivot (16) de ladite au moins une partie comprend un élément d'isolation étanche (161) apte à se déformer élastiquement et assurant l'étanchéité entre la première zone (11) et la deuxième zone (12), lesdits moyens élastiques comprenant l'élément d'isolation étanche (161) de ladite au moins une partie des articulations pivot (16).

11. Système (2) selon la revendication 10, dans lequel chaque articulation pivot (16) de ladite au moins une partie comprend en outre deux lames de torsion (162) s'étendant chacune entre une portion (101) du bâti (10) et la structure de rigidification (152b) de l'électrode mobile (152), lesdits moyens élastiques comprenant en outre les lames de torsion (162) de ladite au moins une partie des articulations pivot (16).

12. Système (2) selon l'une quelconque des revendications 1 à 11, dans lequel les moyens capacitifs de mesure ou d'actionnement (15') comprennent deux contre-électrodes (153, 154) fixes par rapport au bâti (10), une partie au moins de la membrane (152a) de l'électrode mobile (152) étant située entre les deux contre-électrodes (153, 154).

13. Système (2) selon la revendication 12, dans lequel chaque contre-électrode (153, 154) comprend une première portion (153a, 154a) et une deuxième portion (153b, 154b) situées de part et d'autre de la membrane (152a) et de part et d'autre des articulations pivot (16) de ladite au moins une partie, les première et deuxième portions de chaque contre-électrode étant reliées électriquement.

14. Système (2) selon la revendication 13, dans lequel la première portion (153a, 154a) de chaque contre-électrode (153, 154) comprend une pluralité de blocs séparés par la structure de rigidification (152b) de l'électrode mobile (152) et dans lequel chaque bloc de la première portion est relié électriquement à la deuxième portion (153b, 154b) de la contre-électrode (153, 154) par un connecteur (153c, 154c) passant entre deux articulations pivot (16) successives de ladite au moins une partie.

15. Système (2) selon l'une quelconque des revendications 1 à 14, dans lequel les articulations pivot (16) de ladite au moins une partie sont alignées.

## Patentansprüche

1. Elektromechanisches System (2) mit:
- einem Gehäuse (10);
- einem beweglichen Element (13) in Bezug auf das Gehäuse (10), das mit einem ersten Bereich (11) in Kontakt steht;
- kapazitiven Mess- oder Betätigungsmitteln (15') mit einer relativ zum Gehäuse beweglichen Elektrode (152), die in einem zweiten Bereich (12) angeordnet ist, der gegenüber dem ersten Bereich (11) dicht isoliert ist, und mindestens einer relativ zum Gehäuse (10) feststehenden Elektrode (153, 154), die als Gegenelektrode bezeichnet wird, wobei die bewegliche Elektrode (152) eine Membran (152a) und eine Versteifungsstruktur (152b) der Membran umfasst;
- einer Vorrichtung (14') zur Übertragung einer Bewegung zwischen dem beweglichen Element (13) und der beweglichen Elektrode (152), wobei die Übertragungsvorrichtung mittels einer Vielzahl von Schwenkgelenken (16) relativ zum Gehäuse (10) drehbar ist; und
- elastischen Mitteln, die mit der beweglichen Elektrode (152) verbunden und so gestaltet sind, dass sie eine elastische Kraft erzeugen, die der Bewegung der beweglichen Elektrode (152) entgegenwirkt;
**dadurch gekennzeichnet, dass** die Versteifungsstruktur (152b) der beweglichen Elektrode (152) fest mit der Übertragungsvorrichtung (14') verbunden und an der Übertragungsvorrichtung an mindestens einem Teil der Schwenkgelenke (16) verankert ist.

2. System (2) nach Anspruch 1, in dem die Übertragungsvorrichtung (14') erste Elemente umfasst, die sich in der ersten Zone (11) erstrecken, und zweite Elemente (145), die sich teilweise in der ersten Zone (11) und teilweise in der zweiten Zone (12) erstrecken, und in dem die Versteifungsstruktur (152b) der beweglichen Elektrode (152) über die zweiten Elemente (145) mit den ersten Elementen der Übertragungsvorrichtung verbunden ist.

3. System (2) nach Anspruch 2, in dem die ersten Elemente der Übertragungsvorrichtung (14') eine Dicke zwischen 5 µm und 800 µm, vorzugsweise zwischen 50 µm und 200 µm, aufweisen.

4. System (2) nach einem der Ansprüche 2 und 3, in dem die ersten Elemente der Übertragungsvorrichtung (14') zwei Übertragungsarme (141) und einen Querbalken (144) umfassen, der die beiden Übertragungsarme (141) verbindet, wobei jeder der Übertragungsarme ein erstes Ende, das mit dem beweglichen Element (13) gekoppelt ist, und ein zweites Ende aufweist, das fest mit dem Querträger (144) verbunden ist.

5. System (2) nach einem der Ansprüche 1 bis 4, in dem die Versteifungsstruktur (152b) der beweglichen Elektrode (152) mehrere parallel zueinander verlaufende Träger (1521) umfasst und in dem mindestens ein Teil der Träger (1521) an der Übertragungsvorrichtung (14') verankert ist, wobei jeder Träger des mindestens einen Teils an einem dem Träger entsprechenden Schwenkgelenk (16) verankert ist.

6. System (2) nach Anspruch 5, in dem jeder Träger (1521) des mindestens einen Teils in der Mitte seiner Länge an der Übertragungsvorrichtung (14') verankert ist.

7. System (2) nach einem der Ansprüche 5 und 6, in dem jeder Träger (1521) des mindestens einen Teils eine Breite aufweist, die mit zunehmender Entfernung vom entsprechenden Schwenkgelenk (16) abnimmt.

8. System (2) nach einem der Ansprüche 5 bis 7, in dem die Anzahl der Träger (1521) größer oder gleich der Anzahl der Schwenkgelenke (16) des mindestens einen Teils ist.

9. System (2) nach einem der Ansprüche 5 bis 8, das außerdem Mittel (18) umfasst, um ein Zusammenfallen der beweglichen Elektrode (152) zu verhindern, bevor sie die feste Elektrode (153, 154) berührt und einen Kurzschluss verursacht, wobei die Mittel (18) an einem Ende oder an den Enden eines oder mehrerer Träger (1521) angeordnet sind.

10. System (2) nach einem der Ansprüche 1 bis 9, in dem jedes Schwenkgelenk (16) des mindestens einen Teils ein elastisch verformbares Dichtungselement (161) umfasst, das die Abdichtung zwischen dem ersten Bereich (11) und dem zweiten Bereich (12) gewährleistet, wobei die elastischen Mittel das dichte Isolierelement (161) des mindestens einen Teils der Schwenkgelenke (16) umfassen.

11. System (2) nach Anspruch 10, in dem jedes Schwenkgelenk (16) des mindestens einen Teils außerdem zwei Torsionslamellen (162) umfasst, die sich jeweils zwischen einem Abschnitt (101) des Gehäuses (10) und der Versteifungsstruktur (152b) der beweglichen Elektrode (152) erstrecken, wobei die elastischen Mittel außerdem die Torsionslamellen (162) des mindestens einen Teils der Schwenkgelenke (16) umfassen.

12. System (2) nach einem der Ansprüche 1 bis 11, in dem die kapazitiven Mess-oder Betätigungsmittel (15') zwei in Bezug auf das Gehäuse (10) feststehende Gegenelektroden (153, 154) umfassen, wobei mindestens ein Teil der Membran (152a) der beweglichen Elektrode (152) zwischen den beiden Gegenelektroden (153, 154) angeordnet ist.

13. System (2) gemäß Anspruch 12, in dem jede Gegenelektrode (153, 154) einen ersten Abschnitt (153a, 154a) und einen zweiten Abschnitt (153b, 154b) aufweist, die beiderseits der Membran (152a) und beiderseits der Schwenkgelenke (16) des mindestens einen Teils angeordnet sind, wobei der erste und der zweite Abschnitt jeder Gegenelektrode elektrisch miteinander verbunden sind.

14. System (2) gemäß Anspruch 13, in dem der erste Abschnitt (153a, 154a) jeder Gegenelektrode (153, 154) mehrere Blöcke umfasst, die durch die Versteifungsstruktur (152b) der beweglichen Elektrode (152) voneinander getrennt sind, und wobei jeder Block des ersten Abschnitts über ein Verbindungselement (153c, 154c), das zwischen zwei aufeinanderfolgenden Schwenkgelenken (16) des mindestens einen Teils verläuft, mit dem zweiten Abschnitt (153b, 154b) der Gegenelektrode (153, 154) elektrisch verbunden ist.

15. System (2) nach einem der Ansprüche 1 bis 14, in dem die Schwenkgelenke (16) des mindestens einen Teils fluchten.

## Claims

1. Electromechanical system (2) comprising:
- a frame (10);
- an element (13) movable relative to the frame (10), in contact with a first zone (11);
- capacitive measurement or actuation means (15') comprising an electrode (152) movable relative to the frame, located in a second zone (12) which is sealingly insulated from the first zone (11), and at least one electrode (153, 154) fixed relative to the frame (10), referred to as a counter-electrode, the movable electrode (152) comprising a membrane (152a) and a membrane rigidifying structure (152b);
- a device (14') for transmitting movement between the movable element (13) and the movable electrode (152), the transmission device being rotatably movable relative to the frame (10) by means of a plurality of pivot hinges (16); and
- elastic means connected to the movable electrode (152) and configured to generate an elastic force which opposes movement of the movable electrode (152);
**characterised in that** the rigidifying structure (152b) of the movable electrode (152) is secured to the transmission device (14') and anchored to the transmission device at at least one part of the pivot hinges (16).

2. System (2) according to claim 1, wherein the transmission device (14') comprises first elements extending in the first zone (11) and second elements (145) partly extending in the first zone (11) and partly in the second zone (12), and wherein the rigidifying structure (152b) of the movable electrode (152) is connected to the first elements of the transmission device through the second elements (145).

3. System (2) according to claim 2, wherein the first elements of the transmission device (14') have a thickness of between 5 µm and 800 µm, preferably between 50 µm and 200 µm.

4. System (2) according to one of claims 2 and 3, wherein the first elements of the transmission device (14') comprise two transmission arms (141) and a transverse beam (144) connecting the two transmission arms (141), each of the transmission arms comprising a first end coupled to the movable element (13) and a second end secured to the transverse beam (144).

5. System (2) according to any of claims 1 to 4, wherein the rigidifying structure (152b) of the movable electrode (152) comprises a plurality of beams (1521) extending in parallel to each other and wherein at least one part of the beams (1521) is anchored to the transmission device (14'), each beam of said at least one part being anchored at a pivot hinge (16) corresponding to said beam.

6. System (2) according to claim 5, wherein each beam (1521) of said at least one part is anchored to the transmission device (14') at half its length.

7. System (2) according to one of claims 5 and 6, wherein each beam (1521) of said at least one part has a width that decreases with the distance from the corresponding pivot hinge (16).

8. System (2) according to any of claims 5 to 7, wherein the number of beams (1521) is greater than or equal to the number of pivot hinges (16) of said at least one part.

9. System (2) according to any of claims 5 to 8, further comprising means (18) for stopping pull-in of the movable electrode (152) before it touches the fixed electrode (153, 154) and creates a short circuit, said means (18) being located at one end or the ends of one or more beams (1521).

10. System (2) according to any of claims 1 to 9, wherein each pivot hinge (16) of said at least one part comprises a sealed insulation element (161) capable of elastic deformation and ensuring sealing between the first zone (11) and the second zone (12), said elastic means comprising the sealed insulation element (161) of said at least one part of the pivot hinges (16).

11. System (2) according to claim 10, wherein each pivot hinge (16) of said at least one part further comprises two torsion blades (162) each extending between a portion (101) of the frame (10) and the rigidifying structure (152b) of the movable electrode (152), said elastic means further comprising the torsion blades (162) of said at least one part of the pivot hinges (16).

12. System (2) according to any of claims 1 to 11, wherein the capacitive measurement or actuation means (15') comprise two counter-electrodes (153, 154) fixed relative to the frame (10), at least one part of the membrane (152a) of the movable electrode (152) being located between the two counter-electrodes (153, 154).

13. System (2) according to claim 12, wherein each counter-electrode (153, 154) comprises a first portion (153a, 154a) and a second portion (153b, 154b) located on either side of the membrane (152a) and either side of the pivot hinges (16) of said at least one part, the first and second portions of each counter-electrode being electrically connected.

14. System (2) according to claim 13, wherein the first portion (153a, 154a) of each counter-electrode (153, 154) comprises a plurality of blocks separated by the rigidifying structure (152b) of the movable electrode (152) and wherein each block of the first portion is electrically connected to the second portion (153b, 154b) of the counter-electrode (153, 154) by a connector (153c, 154c) passing between two successive pivot hinges (16) of said at least one part.

15. System (2) according to any of claims 1 to 14, wherein the pivot hinges (16) of said at least one part are aligned with each other.
